# EUROPÄISCHE PATENTSCHRIFT

(11) **EP 1 358 715 B1**
(45) Veröffentlichungstag und Bekanntmachung des Hinweises auf die Patenterteilung: **15.08.2012**
(21) Anmeldenummer: 01913610.0
(22) Anmeldetag: 09.02.2001
(51) Int. Cl.: H04B 1/04, H03F 1/02

(54) **VERFAHREN ZUM ENERGIESPARENDEN BETRIEB EINES MOBILFUNKGERÄTES UND MOBILFUNKGERÄT**
METHOD FOR ENERGY-SAVING OPERATION OF A MOBILE RADIO TELEPHONE DEVICE AND MOBILE RADIO TELEPHONE DEVICE
PROCEDE POUR FAIRE FONCTIONNER AVEC ECONOMIE D'ENERGIE UN APPAREIL RADIOTELEPHONIQUE MOBILE ET APPAREIL RADIOTELEPHONIQUE MOBILE

(43) Veröffentlichungstag der Anmeldung: 05.11.2003
(73) Patentinhaber: Hewlett-Packard Development Company, L.P., Houston, TX 77707 (US)
(72) Erfinder: ZOBEC, August, 81927 München (DE)
(74) Vertreter: Samson & Partner
(86) Internationale Anmeldenummer: PCT/DE2001/000521
(87) Internationale Veröffentlichungsnummer: WO 2002/065652

(56) Entgegenhaltungen:
- EP-A- 0 488 385
- EP-A- 0 561 346
- EP-A- 0 803 973
- US-A- 5 670 911

## Beschreibung

Die Erfindung betrifft ein Verfahren zum energiesparenden Betrieb eines Mobilfunkgerätes, mit einem Empfangs- und einem Sendeteil und mindestens einer Verstärkerstufe, unter Variation eines Ruhestromes. Weiterhin betrifft die Erfindung ein Mobilfunkgerät mit einer Verstärkerstufe, die mindestens einen Eingang für ein Eingangssignal, einen Ausgang für ein Ausgangssignal, einen Ruhestrom-Steueranschluß und eine Spannungszuführung aufweist.

Der Markt für Mobilkommunikation erfährt weltweit ein enormes Wachstum. Ermöglicht wird dies durch immer kleinere und preisgünstigere Endgeräte sowie durch leistungsfähige, nach dem GSM-Standard (GSM = Global System for Mobile Communication) konzipierte Mobilkommunikationsnetze.

Derzeit sind in diesem GSM-Mobilfunksystem Datenübertragungsraten von 9,6 kbit/s möglich. Allerdings werden immer höhere Datenübertragungsraten benötigt, da neben dem reinen "Telefon-Handy" die Übertragung von Musik- oder Videodaten (Bildtelefon) sowie der High-Speed-Internet-Zugriff immer größere Bedeutung gewinnt.

Die sogenannte dritte Generation der Mobilkommunikationsnetze ermöglicht diese hohen Datenübertragungsraten. Hierzu werden weltweit das "Future Public Land Mobile Telecommunications System" (FPLMTS) und europaweit das "Universal Mobile Telecommunications System" (UMTS) standardisiert.

Zudem werden bei bereits bestehenden Mobilfunksystemen der zweiten Generation, wie zum Beispiel das GSM-Mobilfunksystem, durch technische Erweiterungen die Datenübertragungsraten signifikant erhöht (z.B. EDGE: Enhanced Data Rate for GSM Evolution). Diese Mobilfunksysteme werden oftmals auch 2.5 oder 2+ Generation genannt.

Für diese Mobilkommunikationsnetze der 3. Generation und der 2.5 Generation werden digitale Modulationsverfahren verwendet, die allerdings nicht mit konstanter Hüllkurve arbeiten, wie dies bei GSM noch der Fall ist. Dies führt zu hohen Linearitätsanforderungen an die Sendeendstufen der Endgeräte dieser Handygeneration. Um die erforderliche Linearität zu gewährleisten, muß ein entsprechend hoher Ruhestrom zur Verfügung gestellt werden, der allerdings einen hohen Batteriestrom zieht und damit einen negativen Einfluß auf die Betriebszeit eines Mobilfunkgerätes hat.

In der Europäischen Patentanmeldung EP 0 896 439 A2 ist ein System der 2+ und 3. Generation beschrieben, das zwischen zwei Ruhestromwerten umschaltet, um Strom zu sparen und so die Betriebszeit des Mobilfunkgerätes zu verlängern. Diese Stromeinsparung ist allerdings für eine effektive Verlängerung der Betriebszeit nicht ausreichend.

<Seite 2a hier einfügen>

Es ist daher Aufgabe der Erfindung, ein Verfahren zum energiesparenden Betrieb eines Mobilfunkgerätes und ein Mobilfunkgerät zur Durchführung des erfindungsgemäßen Verfahrens zur Verfügung zu stellen, das auch bei hohen Linearitätsanforderungen eine Verlängerung der Betriebszeit von Mobilfunkgeräten ermöglicht.

Die Aufgabe zur Entwicklung eines Verfahrens wird durch die Merkmale des ersten Verfahrensanspruches, die Aufgabe zur Entwicklung eines Mobilfunkgerätes wird durch die Merkmale des ersten Vorrichtungsanspruches gelöst.

Der Erfinder hat erkannt, daß lineare Endstufen von Mobilfunkgeräten der 3. Generation vorwiegend mit konstantem

Aus der EP 0 803 973 B1 ist ein Leistungsverstärker bekannt, in dem der Leistungsausgangssignalpegel bestimmt wird und über einen Umsetzer ein Vorspannsignal erzeugt wird, so dass sich der Vorspannungsarbeitspunkt des Leistungsverstärkers so ändert, dass der Leistungszusatzwirkungsgrad im wesentlichen konstant bleibt.

Aus der WO 9401930 ist ein Schaltkreis zur Steuerung der Vorspannung in einem HF-Verstärker mit einem an den Ausgang des HF-Verstärkers gekoppelten Detektor zum Detektieren eines der Ausgangsleistung des HF-Verstärkers proportionalen Signals bekannt. Ruhestrom betrieben werden, oder daß lediglich zwischen zwei Ruhestromwerten umgeschaltet wird. Für eine effektive Stromeinsparung sind diese Systeme jedoch nicht geeignet.

Demgemäß schlägt der Erfinder vor, ein Verfahren zum energiesparenden Betrieb eines Mobilfunkgerätes, mit einem Empfangs- und einem Sendeteil und mindestens einer Verstärkerstufe, unter Variation eines Ruhestromes dahingehend weiterzuentwickeln, daß die Stärke des Ruhestroms der Verstärkerstufe proportional der Aussteuerung dieser Verstärkerstufe gesteuert wird. Hierbei wird die Verstärkerstufe entweder kontinuierlich (analog) oder in einer Vielzahl von Stufen (Schritten), mindestens jedoch in 3 Stufen, vorzugsweise mindestens in 6 Stufen (digitale Steuerung) der Stärke des Ruhestromes angepaßt. Es wird dabei immer nur so viel Ruhestrom bereitgestellt, wie für eine hinreichend verzerrungsarme Signalübertragung durch die Endstufe gerade benötigt wird. Die Steuerung des Ruhestromes der Verstärkerstufe verläuft im Gegensatz zu einer Regelung ohne Rückmessung, was einen wesentlich niedrigeren Realisierungsaufwand zur Folge hat. Weiterhin werden Stabilitätsprobleme der Regelung, die häufig ein Problem in geregelten Systemen darstellen, vermieden. Vorteilhaft ist außerdem, daß bei der Steuerung preiswerte Standardbauteile verwendet werden können.

In einer bevorzugten Ausführung wird die Stärke des Ruhestroms einer vorzugsweise linearen HF-Endstufe (HF-Verstärker) proportional der Aussteuerung der HF-Endstufe gesteuert.

Eine weitere Ausführung des erfindungsgemäßen Verfahrens sieht vor, daß die Stärke des Ruhestroms einer Sendetreiberstufe oder eines ZF-Verstärkers oder eines rauscharmen Vorverstärkers (LNA = Low Noise Amplifier) proportional der Aussteuerung der entsprechenden Verstärkerstufe gesteuert wird. Das erfindungsgemäße Verfahren kann also für jede Verstärkerstufe einer Senderkette, wie zum Beispiel die Sendetreiberstufe oder den ZF-Verstärker, und auch auf jede Verstärkerstufe einer Empfängerkette, wie beispielsweise den rauscharmen Vorverstärker oder den ZF-Verstärker, angewendet werden.

In einer weiteren Ausführung des Verfahrens wird die Stärke des Ruhestroms direkt proportional der Aussteuerung der Endstufe gesteuert. Bei voller Aussteuerung wird die Endstufe mit maximal zulässigem Ruhestrom versorgt, wogegen bei reduzierter Aussteuerung auch der Ruhestrom der Endstufe entsprechend reduziert wird. Eine untere Grenze für die Ruhestromeinstellung ist physikalisch bedingt dadurch gegeben, daß die Verzerrungsprodukte einer Endstufe (HF-Verstärker) mit abnehmendem Ruhestrom immer mehr zunehmen. Durch diese Ausführung ist eine Stromeinsparung in der Größenordnung von beispielsweise ca. 100 mA bei Mobilfunkgeräten möglich.

Eine Ausführung des erfindungsgemäßen Verfahrens sieht vor, daß ein Signalanteil ausgekoppelt, weitergeleitet und detektiert wird, und je nach Signalgröße der Ruhestrom über ein Steuersignal angepaßt wird. Die Auskopplung eines Signalanteils kann vor dem Eingang der Endstufe erfolgen, beispielsweise mit Hilfe eines Richtkopplers oder Leistungsteilers. Dieser ausgekoppelte Signalanteil wird zum Beispiel von einem Detektor detektiert und gleichgerichtet. Das Gleichspannungssignal am Ausgang des Detektors kann nun über einen nachfolgenden NF-Verstärker ein Steuersignal erzeugen, das den Ruhestrom der Endstufe steuert.

In einer weiteren Ausführung erzeugt eine digitale Steuerelektronik das Steuersignal, das den Ruhestrom der Endstufe steuert. Dies hat den Vorteil, daß analoge Hardware, wie zum Beispiel der NF-Verstärker, entfallen kann.

Da das Steuersignal für den Ruhestrom proportional dem Detektorausgangssignal, und dieses proportional dem ausgekoppelten Signalanteil des Eingangssignals ist, ist auch der Ruhestrom proportional der Leistung des Eingangssignals (Eingangsleistung).

In einer anderen Variante des erfindungsgemäßen Verfahrens wird ein Spannungsabfall in der Spannungszuführung der Endstufe über einen Strommeßwiderstand einem NF-Verstärker oder einer digitalen Steuerelektronik zugeführt, der dann über ein Steuersignal den Ruhestrom der Endstufe steuert. Hier kann anstelle des Richtkopplers und des Detektors ein Strommeßwiderstand in der Spannungzuführung der Endstufe verwendet werden, denn die Stromaufnahme dieser Endstufe ist proportional zu der Leistung des Ausgangssignals (Ausgangsleistung) der Endstufe.

Der Erfinder schlägt weiterhin vor, ein Mobilfunkgerät mit einer Verstärkerstufe, die mindestens einen Eingang für ein Eingangssignal, einen Ausgang für ein Ausgangssignal, einen Ruhestrom-Steueranschluß und eine Spannungszuführung aufweist, dahingehend weiterzuentwickeln, daß ein Mittel zur proportionalen Steuerung des Ruhestroms der Verstärkerstufe vorgesehen ist.

Vorteilhaft ist als Verstärkerstufe eine vorzugsweise lineare HF-Endstufe vorgesehen, das heißt eine Endstufe für Modulationsverfahren, die mit nicht konstanter Hüllkurve arbeiten. Weiterhin können auch Endstufen, die für Modulationsverfahren mit konstanter Hüllkurve verwendet werden, und an die nur geringere Anforderungen an die Linearität gestellt werden, vorgesehen sein.

Darüber hinaus kann als Verstärkerstufe jede Verstärkerstufe einer Senderkette, wie zum Beispiel eine Sendetreiberstufe oder ein ZF-Verstärker, sowie auch jede Verstärkerstufe einer Empfängerkette, wie beispielsweise ein rauscharmer Vorverstärker oder ein ZF-Verstärker, vorgesehen sein.

Eine Ausgestaltung des erfindungsgemäßen Mobilfunkgerätes sieht vor, daß das Mittel zur proportionalen Steuerung des Ruhestroms einen Richtkoppler oder einen Leistungsteiler aufweist, der einen Teil eines Signals auskoppelt. Hierbei kann das Signal das Eingangssignal am Eingang der Endstufe sein.

Weiterhin kann das Mittel zur proportionalen Steuerung des Ruhestroms einen Detektor aufweisen, der zum Beispiel als Diodendetektor ausgeführt ist, der den ausgekoppelten Signalanteil gleichrichtet und das gleichgerichtete Detektorausgangssignal weiterleitet. Hierbei ist das Detektorausgangssignal proportional zu dem Detektoreingangssignal, also proportional dem ausgekoppelten Signalanteil.

In einer Weiterentwicklung des Mobilfunkgerätes weist das Mittel zur proportionalen Steuerung des Ruhestroms einen NF-Verstärker, wie zum Beispiel einen Operationsverstärker auf, der, je nach Detektorausgangssignal, ein Steuersignal zur Ruhestrom-Steuerung der Endstufe generiert. Ist das Detektorausgangssignal niedrig, bewirkt dieses Steuersignal einen reduzierten Ruhestrom, ist das Detektorausgangssignal maximal, wird die Endstufe so gesteuert, daß sie mit maximal zulässigem Ruhestrom versorgt wird.

In einer weiteren Ausführung des Mobilfunkgerätes weist das Mittel zur proportionalen Steuerung des Ruhestroms eine digitale Steuerelektronik auf, die das Steuersignal zur Ruhestrom-Steuerung der Verstärkerstufe generiert.

In einer vorteilhaften Weiterentwicklung weist die digitale Steuerelektronik eine Softwaretabelle auf. Diese Softwaretabelle kann die Kennwerte des HF-Verstärkers enthalten, also die Leistung des Ausgangssignals (Ausgangsleistung), die Leistung des Eingangssignals (Eingangsleistung) und den Ruhestrom, wobei die Ausgangsleistung beziehungsweise der Verstärkungsfaktors der Endstufe abhängig ist von der Eingangsleistung und von der Ruhestromeinstellung. Diese Ausführung hat den Vorteil, daß auf analoge Hardware gänzlich verzichtet werden kann.

Auf die Auskopplung der Leistung des Eingangssignals mittels Leistungsteiler oder Richtkoppler kann verzichtet werden, da meist die Verstärkungsfaktoren der einzelnen Verstärkerstufen der gesamten Verstärkerkette (Basisband über ZF bis Sendetreiber) vor der HF-Endstufe bekannt sind, und somit auch die Leistung des Eingangssignals der Endstufe bekannt ist. Ist nun der Verstärkungsfaktor bzw. die Leistung des Ausgangssignals der Endstufe in Abhängigkeit von der Leistung des Eingangssignals und von der Ruhestromeinstellung bekannt (Kennwerte der Endstufe), so ist auch der Verstärkungsfaktor bzw. die Leistung des Ausgangssignals der gesamten Verstärkerkette inklusive der Endstufe bekannt.

Weiterhin können Detektor und NF-Verstärker entfallen, da die Steuerung des Ruhestroms nun mit Hilfe der Werte der Softwaretabelle erfolgt, wobei selbst mehrdimensionale umfangreiche Tabellen in Echtzeit verarbeitet werden können.

Ein weiteres Ausführungsbeispiel des erfindungsgemäßen Mobilfunkgerätes sieht vor, daß das Mittel zur Steuerung des Ruhestroms einen Strommeßwiderstand aufweist, der einen Spannungsabfall weiterleitet und dem NF-Verstärker oder der digitalen Steuerelektronik zuführt. Hier kann der NF-Verstärker oder die digitale Steuerelektronik je nach Spannungsabfall ein Steuersignal zur Ruhestrom-Steuerung der Endstufe erzeugen.

Es versteht sich, daß sich die Erfindung auch auf Modulationsverfahren mit konstanter Hüllkurve, wie zum Beispiel GMSK (Gaussian Minimum Shift Keying), im GSM-Mobilfunksystem, übertragen läßt. Auch wenn bei den Endstufen dieser Systeme nur geringe Anforderungen an die Linearität gestellt wird, und somit der Ruhestromverbrauch gering gehalten wird, bietet die erfindungsgemäße Ruhestrom-Steuerung auch hier ein Potential für eine Sprechzeiterhöhung.

Weitere Merkmale der Erfindung ergeben sich aus der nachfolgenden Beschreibung eines Ausführungsbeispiels unter Bezugnahme auf die Zeichnungen. Es zeigen:
- Figur 1:: Ruhestrom-Steuerung durch die Ableitung eines Steuersignals aus einem Eingangssignal am Eingang der HF-Endstufe;

- Figur 2:: Ruhestrom-Steuerung durch die Ableitung eines Steuersignals über eine Messung der Stromaufnahme der HF-Endstufe.
- Figur 3:: Ruhestrom-Steuerung durch die Ableitung eines Steuersignals aus dem Eingangssignal am Eingang der HF-Endstufe mit Hilfe einer digitalen Steuerelektronik, wobei Kennwerte der HF-Endstufe als Softwaretabelle abgespeichert sind.

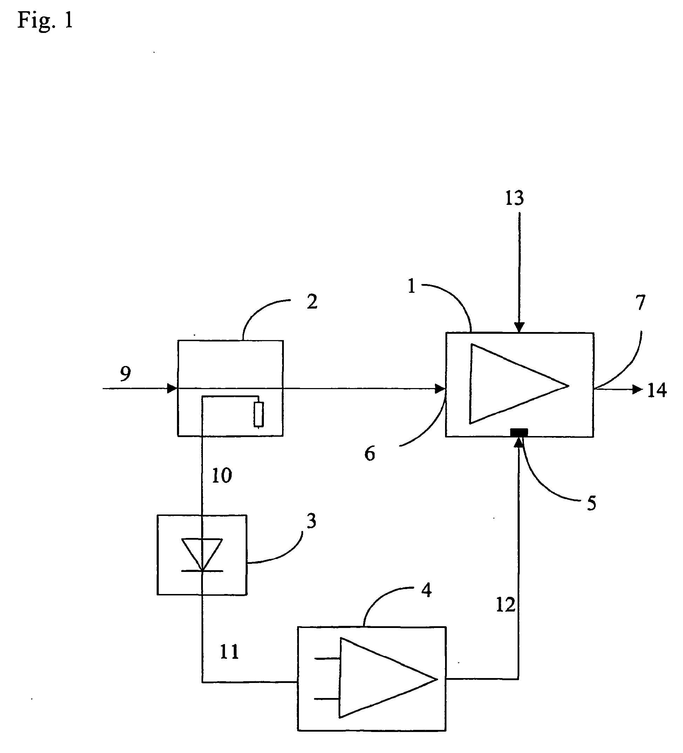

Die Figur 1 zeigt ein erstes Ausführungsbeispiel der Erfindung, mit einer Endstufe 1 (HF-Verstärker), einem Richtkoppler 2, einem Detektor 3 und einem NF-Verstärker 4, zum Beispiel einem Operationsverstärker 4, wobei ein Steuersignal 12 über ein Eingangssignal 9 der Endstufe 1 abgeleitet wird. Der HF-Verstärker 1 hat einen Eingang 6, einen Ausgang 7, einen Ruhestrom-Steueranschluß 5 sowie eine Spannungszuführung 13.

Vor dem Eingang 6 des HF-Verstärkers 1 wird über einen Richtkoppler 2 ein Signalanteil 10 des Eingangssignals 9 ausgekoppelt und dem nachfolgenden Detektor 3 zugeführt. Am Ausgang des Detektors 3 steht nun ein, der Leistung des Eingangssignals 9 proportionales Gleichspannungssignal 11 zur Verfügung. Der nachfolgende NF-Verstärker 4 generiert hieraus ein Steuersignal 12, das über den Ruhestrom-Steueranschluß 5 des HF-Verstärkers 1 den Ruhestrom der Endstufe 1 steuert.

Das Gleichspannungssignal 11 am Ausgang des Detektors 3 steigt mit zunehmender Leistung des Eingangssignals 9 an und sinkt mit abnehmender Leistung.

Weiterhin dient der NF-Verstärker 4 dazu, die Kennlinie des Detektors 3 (Detektorausgangssignal 11 in Abhängigkeit von der Leistung des Eingangssignals 9) an die Ruhestrom-Steuerkennlinie des HF-Verstärkers 1 (Leistung des Ausgangssignals 14 des HF-Verstärkers 1 in Abhängigkeit von einer Steuerspannung oder einem Steuerstrom bzw. dem Ruhestrom der Endstufe 1) anzupassen.

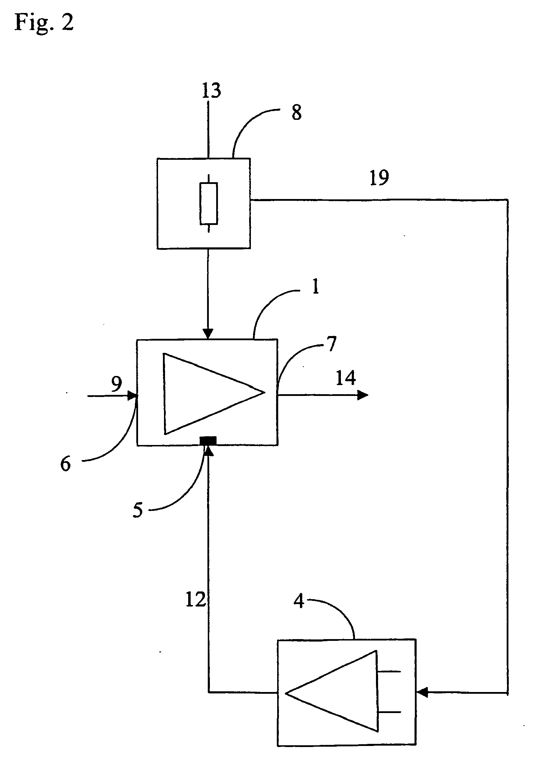

Die Figur 2 zeigt ein zweites Ausführungsbeispiel, wobei das Steuersignal 12 über eine Stromaufnahme der Endstufe 1 abgeleitet wird. Da die Stromaufnahme der Endstufe 1 proportional zur Ausgangsleistung der HF-Endstufe 1 ist, wird zur Messung dieser Stromaufnahme ein Strommeßwiderstand 8 in der Spannungszuführung 13 des HF-Verstärkers 1 verwendet. Dabei wird der Spannungsabfall über dem Strommeßwiderstand 8 direkt dem NF-Verstärker 4 zugeführt, der dann ein Steuersignal 12 generiert, den Ruhestrom-Steueranschluß 5 ansteuert und so den Ruhestrom der Endstufe 1 steuert.

Weiterhin dient der NF-Verstärker 4 dazu, die Kennlinie des Strommeßwiderstandes 8 (Ausgangssignal 19 des Strommeßwiderstandes 8 in Abhängigkeit von der Stromaufnahme des HF-Verstärkers 1) an die Ruhestrom-Steuerkennlinie des HF-Verstärkers 1 (Leistung des Ausgangssignals 14 des HF-Verstärkers 1 in Abhängigkeit von der Steuerspannung oder Steuerstrom bzw. dem Ruhestrom der Endstufe 1) anzupassen.

Dieses erfindungsgemäße Ausführungsbeispiel hat den Vorteil, daß gegenüber den Ausführungsbeispielen der Figuren 1 und 2 der Richtkoppler und der Detektor entfallen.

Für die Ausführungsbeispiele nach den Figuren 1 und 2 gilt weiterhin, daß anstelle des NF-Verstärkers 4 auch eine digitale Steuerelektronik zur Anpassung der Detektorkennlinie beziehungsweise des Ausgangssignals des Strommeßwiderstandes 8 an die Ruhestrom-Steuerkennlinie des HF-Verstärkers 1 verwendet werden kann.

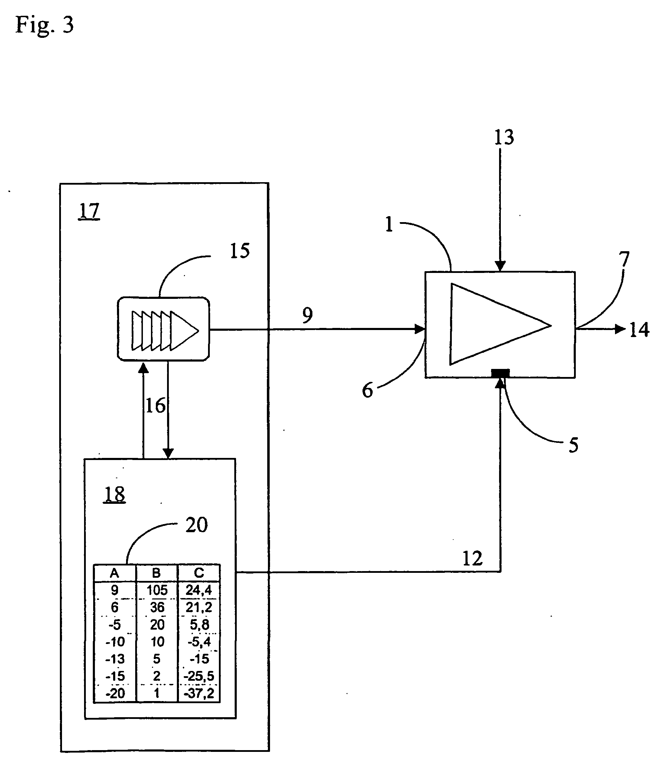

Die Figur 3 zeigt ein drittes Ausführungsbeispiel der Erfindung, mit einem HF-Verstärker 1 und einem Funktionsblock 17 eines Mobiltelefons, der eine Verstärkerkette 15 (inklusive Basisband-Verstärker und ZF-Verstärker), Steuerleitungen 16 und eine digitale Steuerelektronik 18 mit einer Softwaretabelle 20 aufweist. Hier wird die Ruhestrom-Steuerung durch die Ableitung eines Steuersignals 12 aus einem Eingangssignal 9 am Eingang 6 des HF-Verstärkers 1 mit Hilfe der digitalen Steuerelektronik 18 erreicht, wobei die Kennwerte des HF-Verstärkers 1, also die Eingangsleistung, die Ausgangsleistung und die Ruhestromeinstellung als Softwaretabelle 20 abgespeichert sind.

Diese Softwaretabelle 20 ist als dreidimensionale Wertetabelle mit den Spalten A, B und C aufgebaut. Hierin sind, beispielsweise in der Spalte A, die Werte für die Leistung des Eingangssignals 9 in dBm, in der Spalte B die Werte für die Ruheströme in mA und in der Spalte C die Werte für die Leistung des Ausgangssignals 14 in dBm enthalten. Hierbei ist die Leistung des Ausgangssignals 14 beziehungsweise des Verstärkungsfaktors der HF-Endstufe 1 von der Leistung des Eingangssignals 9 und von der Ruhestromeinstellung abhängig.

Mit Hilfe dieser Wertetabelle generiert die digitale Steuerelektronik 18 je nach Eingangssignal 9 ein Steuersignal 12, das über den Ruhestrom-Steueranschluss 5 den Ruhestrom der HF-Endstufe 1 steuert. Weiterhin stellt die digitale Steuerelektronik 18 über die Steuerleitungen 16 mit Hilfe der Verstärkerkette 15 die Leistung des Eingangssignals 9 der HF-Endstufe 1 bereit.

Die Steuerleitungen 16 sind mit Hilfe zweier Pfeile dargestellt. Hierbei soll der Pfeil 16 von der Verstärkerkette 15 zur digitalen Steuerelektronik 18 verdeutlichen, daß der Ausgangspegel der Verstärkerkette 15 (ist gleich der Leistung des Eingangssignals 9 des HF-Verstärkers 1) der digitalen Steuerelektronik 18 bekannt ist. Der Pfeil 16 in der Gegenrichtung von der digitalen Steuerelektronik 18 zur Verstärkerkette 15 zeigt, daß die digitale Steuerelektronik 18 die Leistung des Eingangssignals 9 des HF-Verstärkers 1 über die Verstärkerkette 15 steuert.

Dieses Ausführungsbeispiel enthält außer dem RuhestromSteueranschluss 5 des HF-Verstärkers 1 keine weitere analoge Hardware. Der Realisierungsaufwand wird also in die Software der digitalen Steuerung 18 verlagert. Diese Ausführung des Mobilfunkgerätes unterstützt den Trend zu weiterer Integration, Miniaturisierung und Kostenreduktion.

Es versteht sich, daß die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

Insgesamt wird durch die Erfindung erreicht, daß durch die Anpassung des Ruhestroms an die jeweilige Aussteuerung der Endstufe erheblich Strom (Energie) eingespart wird, wodurch sich sowohl Sprechzeit als auch Betriebszeit eines Mobilfunkgerätes erhöht.

## Patentansprüche

1. Verfahren zum energiesparenden Betrieb eines Mobilfunkgerätes, mit einem Empfangs- und einem Sendeteil und mindestens einer Verstärkerstufe, unter Variation eines Ruhestromes, wobei die Stärke des Ruhestroms der Verstärkerstufe proportional der Aussteuerung dieser Verstärkerstufe gesteuert wird, indem ein Signalanteil (10) eines an die Verstärkerstufe angelegten Eingangssignals (9) ausgekoppelt, weitergeleitet und detektiert wird, und der Ruhestrom über ein zur Signalgröße des Signalanteils proportionales Steuersignal (12) angepasst wird.

2. Verfahren gemäß dem voranstehenden Anspruch 1, **dadurch gekennzeichnet, dass** die Stärke des Ruhestroms einer, vorzugsweise linearen, HF-Endstufe eines HF-Verstärkers (1) proportional der Aussteuerung der HF-Endstufe (1) gesteuert wird.

3. Verfahren gemäß einem der voranstehenden Ansprüche 1 bis 2, **dadurch gekennzeichnet, dass** die Stärke des Ruhestroms einer Sendetreiberstufe und/oder eines ZF-Verstärkers und/oder eines rauscharmen Vorverstärkers proportional der Aussteuerung der jeweiligen Verstärkerstufe gesteuert wird.

4. Verfahren gemäß einem der voranstehenden Ansprüche 1 bis 3 , **dadurch gekennzeichnet, dass** die Stärke des Ruhestroms direkt proportional der Aussteuerung der Verstärkerstufe gesteuert wird.

5. Verfahren gemäß einem der voranstehenden Ansprüche 1 bis 5, **dadurch gekennzeichnet, dass** ein Spannungsabfall in der Spannungszuführung (13) der Verstärkerstufe über einen Strommesswiderstand (8) einem NF-Verstärker (4) oder einer digitalen Steuerelektronik (18) zugeführt wird, der dann über ein Steuersignal (12) den Ruhestrom der Verstärkerstufe steuert.

6. Mobilfunkgerät mit einer Verstärkerstufe, die mindestens einen Eingang (6) für ein Eingangssignal (9), einen Ausgang (7) für ein Ausgangssignal (14), einen Ruhestromsteueranschluss (5), eine Spannungszuführung (13) und ein Mittel zur proportionalen Steuerung des Ruhestroms der Verstärkerstufe aufweist, wobei das Mittel zur proportionalen Steuerung des Ruhestroms
- einen Richtkoppler (2) oder einen Leistungsteiler, der einen Signalanteil (10) eines an die Verstärkerstufe angelegten Eingangssignals (9) auskoppelt,
- weiterhin einen Detektor (3) , der den ausgekoppelten Signalanteil (10) gleichrichtet und ein gleichgerichtetes Detektorausgangssignal (11) weiterleitet
- und einen NF-Verstärker (4), der ein Steuersignal (12) zur Ruhestrom-Steuerung der Verstärkerstufe generiert,
aufweist.

7. Mobilfunkgerät gemäß dem voranstehenden Anspruch 6, **dadurch gekennzeichnet, dass** als Verstärkerstufe eine vorzugsweise lineare HF-Endstufe (1) vorgesehen ist.

8. Mobilfunkgerät gemäß einem der voranstehenden Ansprüche 6 bis 7, **dadurch gekennzeichnet, dass** als Verstärkerstufe eine Sendetreiberstufe und/oder ein ZF-Verstärker und/oder ein rauscharmer Vorverstärker vorgesehen ist.

9. Mobilfunkgerät gemäß einem der voranstehenden Ansprüche 6 bis 8, **dadurch gekennzeichnet, dass** das Mittel zur proportionalen Steuerung des Ruhestroms eine digitale Steuerelektronik (18) aufweist, die ein Steuersignal (12) zur Ruhestrom-Steuerung der Verstärkerstufe generiert.

10. Mobilfunkgerät gemäß dem voranstehenden Anspruch 9, **dadurch gekennzeichnet, dass** die digitale Steuerelektronik (18) eine Softwaretabelle (20) aufweist.

11. Mobilfunkgerät gemäß einem der voranstehenden Ansprüche 6 bis 10, **dadurch gekennzeichnet, dass** das Mittel zur Steuerung des Ruhestroms einen Strommesswiderstand (8) aufweist, der einen Spannungsabfall weiterleitet und einem NF-Verstärker (4) oder einer digitalen Steuerelektronik (18) zuführt.

## Claims

1. Method for energy-saving operation of a mobile radio telephone device, comprising a receiver part and a transmitter part and at least one amplifier stage, with variation of a closed-circuit current, the intensity of the closed-circuit current of the amplifier stage being controlled in proportion to the control level of this amplifier stage by decoupling, relaying, and detecting a signal component (10) of an input signal (9) that is applied to the amplifier stage, and adapting the closed-circuit current via a control signal (12) which is proportional to the signal strength of the signal component.

2. Method according to preceding Claim 1, **characterized in that** the intensity of the closed-circuit current of an HF output stage, which is preferably linear, of an HF amplifier (1) is controlled in proportion to the control level of the HF output stage (1).

3. Method according to one of preceding Claims 1 through 2, **characterized in that** the intensity of the closed-circuit current of a transmitter driver stage and/or of an IF amplifier and/or of a low-noise pre-amplifier is controlled in proportion to the control level of the particular amplifier stage.

4. Method according to one of preceding Claims 1 through 3, **characterized in that** the intensity of the closed-circuit current is controlled in direct proportion to the control level of the amplifier stage.

5. Method according to one of preceding Claims 1 through 5, **characterized in that** a voltage drop in the voltage supply (13) of the amplifier stage is provided via a shunt (8) to an LF amplifier (4) or digital control electronics system (18), which then controls the closed-circuit current of the amplifier stage via a control signal (12).

6. Mobile radio telephone device comprising an amplifier stage which has at least one input (6) for an input signal (9), at least one output (7) for an output signal (14), a closed-circuit current control connection (5), a power supply (13), and a means for proportional control of the closed-circuit current of the amplifier stage, the means for proportional control of the closed-circuit current having
- a directional coupler (2) or a power splitter which decouples a signal component (10) of an input signal (9) that is applied to the amplifier stage,
- a detector (3) which rectifies the decoupled signal component (10) and relays a rectified detector output signal (11), and
- an LF amplifier (4) which generates a control signal (12) for the closed-circuit current control of the amplifier stage.

7. Mobile radio telephone device according to preceding Claim 6, **characterized in that** a preferably linear HF output stage (1) is provided as the amplifier stage.

8. Mobile radio telephone device according to one of preceding Claims 6 through 7, **characterized in that** a transmitter driver stage and/or an IF amplifier and/or a low-noise pre-amplifier is provided as the amplifier stage.

9. Mobile radio telephone device according to one of preceding Claims 6 through 8, **characterized in that** the means for proportional control of the closed-circuit current has a digital control electronics system (18) which generates a control signal (12) for the closed-circuit current control of the amplifier stage.

10. Mobile radio telephone device according to preceding Claim 9, **characterized in that** the digital control electronics system (18) has a software table (20).

11. Mobile radio telephone device according to one of preceding Claims 6 through 10, **characterized in that** the means for controlling the closed-circuit current has a shunt (8) which relays a voltage drop and delivers same to an LF amplifier (4) or a digital control electronics system (18).

## Revendications

1. Procédé pour le fonctionnement avec économie d'énergie d'un appareil radio mobile, comportant une unité de réception et une unité d'émission et au moins un étage d'amplification, en faisant varier un courant de repos, l'intensité du courant de repos de l'étage d'amplification étant commandée de manière proportionnelle au signal d'attaque de cet étage d'amplification, dans lequel une partie (10) d'un signal d'entrée (9) injecté à l'étage d'amplification est découplée, transmise et détectée, et le courant de repos est adapté à l'aide d'un signal de commande (12) proportionnel à l'amplitude de la partie de signal.

2. Procédé selon la précédente revendication 1, **caractérisé par le fait que** l'intensité du courant de repos d'un étage HF final, de préférence linéaire, d'un amplificateur HF (1) est commandée proportionnellement au signal d'attaque de l'étage HF final.

3. Procédé selon l'une des revendications précédentes 1 et 2, **caractérisé par le fait que** l'intensité du courant de repos d'un étage d'amplificateur d'émission et/ou d'un amplificateur de FI et/ou d'un préamplificateur à faible bruit est commandée proportionnellement au signal d'attaque de l'étage d'amplification considéré.

4. Procédé selon l'une des revendications précédentes 1 à 3, **caractérisé par le fait que** l'intensité du courant de repos est commandée de manière directement proportionnelle au signal d'attaque de l'étage d'amplification.

5. Procédé selon l'une des revendications précédentes 1 à 3, **caractérisé par le fait qu'**une chute de tension dans l'alimentation en tension (13) de l'étage d'amplification est envoyée à l'aide d'une résistance de mesure du courant (8) à un amplificateur BF (4) ou à un module électronique de commande numérique (18) qui pilote ensuite le courant de repos de l'étage d'amplification à l'aide d'un signal de commande (12).

6. Appareil radio mobile comportant un étage d'amplification qui possède au moins une entrée (6) pour un signal d'entrée (9), une sortie (7) pour un signal de sortie (14), un raccordement de commande du courant de repos (5), une alimentation en tension (13) et un moyen de commande proportionnelle du courant de repos de l'étage d'amplification, le moyen de commande proportionnelle du courant de repos comprenant :
- un coupleur directif (2) ou un diviseur de puissance qui découple une partie (10) d'un signal d'entrée (9) injecté à l'étage d'amplification ;
- ainsi qu'un détecteur (3) qui redresse la partie de signal (10) découplée et transmet un signal de sortie (11) redressée du détecteur ;
- et un amplificateur BF (4) qui produit un signal de commande (12) pour la commande du courant de repos de l'étage d'amplification.

7. Appareil radio mobile selon la précédente revendication 6, **caractérisé par le fait qu'**il est prévu comme étage d'amplification un étage final HF (1) de préférence linéaire.

8. Appareil radio mobile selon l'une des revendications précédentes 6 et 7, **caractérisé par le fait qu'**il est prévu comme étage d'amplification un étage d'amplificateur d'émission et/ou un amplificateur de FI et/ou un préamplificateur à faible bruit.

9. Appareil radio mobile selon l'une des revendications précédentes 6 à 8, **caractérisé par le fait que** le moyen de commande proportionnelle du courant de repos possède un module électronique de commande numérique (18) qui produit un signal de commande (12) pour la commande du courant de repos de l'étage d'amplification.

10. Appareil radio mobile selon la précédente revendication 9, **caractérisé par le fait que** l'électronique de commande numérique (18) comprend un tableau logiciel (20).

11. Appareil radio mobile selon l'une des revendications précédentes 6 à 10, **caractérisé par le fait que** le moyen de commande du courant de repos comprend une résistance de mesure du courant (8) qui transmet une chute de tension et alimente un amplificateur BF (4) ou un module électronique de commande numérique (18).
